# EUROPEAN PATENT SPECIFICATION

(11) **EP 1 139 562 B1**
(45) Date of publication and mention of the grant of the patent: **16.03.2005**
(21) Application number: 00106983.0
(22) Date of filing: 01.04.2000
(51) Int. Cl.: H03G 3/34

(54) **Radio with a squelch circuit, and method**
Radio mit Rauschsperrenschaltung und zugehöriges Verfahren
Poste radio avec circuit silencieux et procédé associé audit circuit silencieux

(43) Date of publication of application: 04.10.2001
(73) Proprietor: MOTOROLA, INC., Schaumburg, IL 60196 (US)
(72) Inventor: Hammes, Bernhard, 65329 Hohenstein (DE); Bingel, Reiner, 65558 Eppenrod (DE); König, Hartmut, 65232 Taunusstein-Orlen (DE); Brenner, Wolfgang, 65326 Aarbergen Rückershausen (DE)
(74) Representative: McCormack, Derek James

(56) References cited:
- US-A- 5 303 408
- "Noise-Gate für den Amateur" FUNKSCHAU., vol. 51, no. 19, September 1979 (1979-09), XP002145964 FRANZIS-VERLAG K.G. MUNCHEN., DE ISSN: 0016-2841
- PATENT ABSTRACTS OF JAPAN vol. 008, no. 004 (E-220), 10 January 1984 (1984-01-10) & JP 58 171116 A (MATSUSHITA DENKI SANGYO KK), 7 October 1983 (1983-10-07)

## Description

### Field of the Invention

This invention generally relates to radios, and more particularly, to a radio having a squelch circuit.

### Background of the Invention

Radios often have squelch circuits that continuously monitor the radio frequency (RF) input to mute the loudspeaker if the RF signal is absent. The squelch feature is often used for radios in a car because the RF reception varies with the location of the car. Examples are one-way frequency modulation (FM) radios to receive public or private broadcast or two-way radio for taxi dispatching purposes. Such radios often have a user operated switch to enable or disable the squelch feature. When squelching is disabled, the speaker might output fully amplified noise. This is not wanted. Besides discomfort, an unexpectedly high sound level is a safety and health concern. The car driver might be distracted and might cause a road accident. Damage to the ear might result too.

### Summary of the Invention

According to a first aspect of the present invention there is provided a radio as claimed in claim 1.

According to a second aspect of the present invention there is provided a radio as claimed in claim 4.

According to a third aspect of the present invention there is provided a method for operating a radio as claimed in claim 9.

Further features of the present invention are defined in the dependent Claims.

### Brief Description of the Drawings

- FIG. 1: illustrates a simplified block diagram of a prior art radio having a squelch circuit;
- FIG. 2: illustrates a state diagram for the radio of FIG. 1;
- FIG. 3: illustrates a simplified block diagram of a radio having an extended squelch circuit according to the present invention;
- FIG. 4: illustrates a state diagram for the radio of FIG. 3;
- FIG. 5: illustrates a simplified sound-level-to-gain diagram of the radio according to the present invention; and
- FIG. 6: illustrates a simplified block diagram of a radio according to the present invention in a digital signal processor (DSP) implementation.

### Detailed Description of a Preferred Embodiment

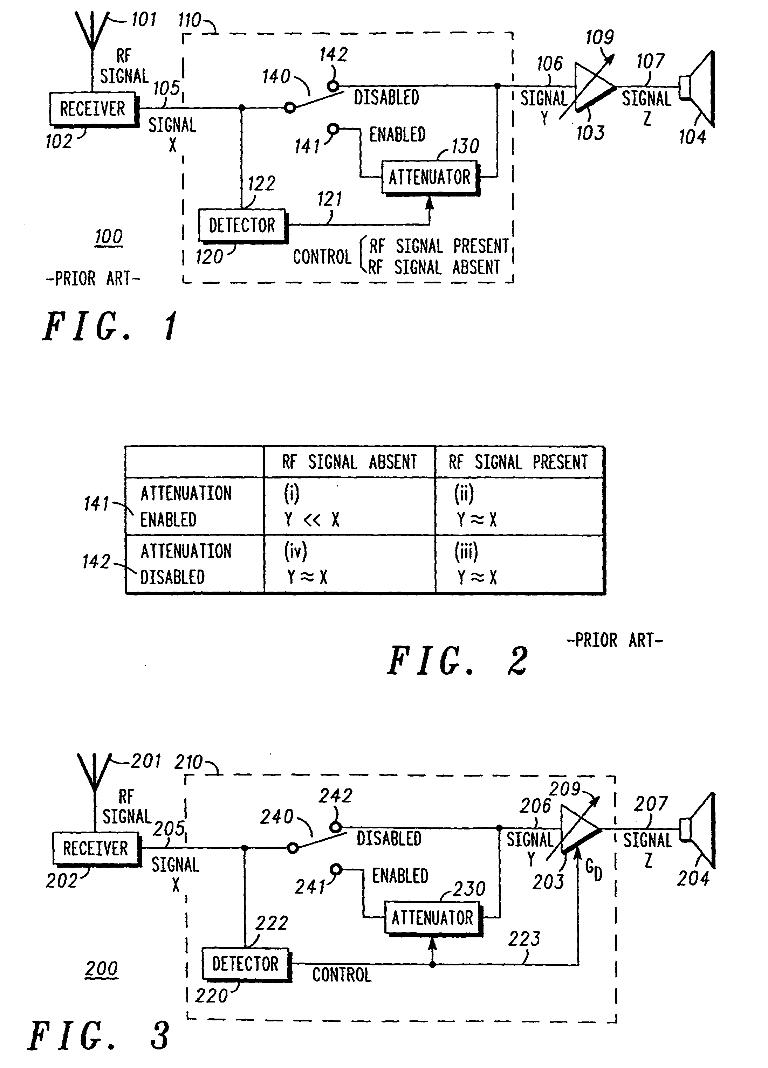

FIG. 1 illustrates a simplified block diagram of radio 100 having squelch circuit 110 (dashed frame). Radio 100 comprises antenna 101, receiver 102, audio amplifier 103, speaker 104, signal line 105 (signal X), signal line 106 (signal Y) and signal line 107 (signal Z), and - forming circuit 110 - detector 120, controllable attenuator 130, and switch 140.

Receiver 102 receives the radio frequency (RF) signal having a predetermined frequency from antenna 101. Receiver 102 demodulates the RF signal to intermediate signal X (e.g., at audio frequency 10 Hz ... 15 kHz) at signal line 105.

In a first case, the RF signal is present and signal X is an information carrying signal (e.g., voice, music, data) hereinafter collectively referred to as "voice signal"; in a second case, the RF signal is absent so that signal X is a noise signal. The term "absent" is intended here to represent that a RF carrier is below a predetermined threshold. Often, the amplitude of the noise signal is much higher than the amplitude of the voice signal. Therefore, noise would appear to the user louder than voice. In other words, when the carrier is disappearing, the noise is increasing.

Squelch circuit 110 forwards signal X to line 106 at the input of amplifier 103. Amplifier 103 has a user operated gain controller 109 (gain G, "volume setting") indicated here by an arrow. Gain controller 109 is implemented, for example, by an analog potentiometer resistor, or by digital circuitry. Amplifier 103 outputs signal Z (amplitude Z = G * Y) to speaker 104.

In squelch circuit 110, detector 120 analyses signal X to detect the presence or absence of the RF signal and thereby predicts whether signal X is a voice signal or a noise signal. Detector 120 provides control signal CONTROL in a first state (SIGNAL PRESENT, X voice) and in a second state (SIGNAL ABSENT, X noise).

Having input 122 of detector 120 illustrated to receive signal X is convenient for explanation; detector 120 can also analyze any other signals within receiver 102.

As mentioned above, switch 140 is operated by the user. In position 141 the attenuation is enabled (ENABLED) and signal 105 on line 105 goes to line 106 (becoming signal Y) via attenuator 130. In position 142, the attenuation is disabled (DISABLED) and signal X goes directly from line 105 to line 106 to become signal Y. Attenuator 130 receives control signal CONTROL from detector 120 via line 121 to attenuate only the noise.

FIG. 2 illustrates a state diagram for radio 100 of FIG. 1. The left column indicates the position of switch 140: either attenuation enabled (141) or attenuation disabled (142) as determined by the user; the top row indicates the absence or the presence of the RF signal as detected by detector 120. Four different states can be distinguished:
(i) The attenuation is enabled, but the RF signal is absent (i.e., X noise). Attenuator 130 attenuates the amplitude of signal X to a substantially smaller amplitude of signal Y (i.e. Y << X). Typically, the amplitude of signal Y is about zero.
(ii) The attenuation is enabled and the RF signal is present (i.e., X voice) so that detector 120 causes attenuator 130 to forward signal X without substantially changing the amplitude (i.e. Y ≈ X).
   When the user has enabled attenuation, radio 100 automatically switches from (i) to (ii) or vice versa so that speaker 104 either remains substantially silent or outputs voice.
(iii) The attenuation is disabled so that switch 140 forwards signal X directly to amplifier 103. The RF signal is present (i.e., X voice) and signal amplitudes of X and Y are substantially equal.
(iv) The attenuation is disabled so that switch 140 also forwards signal X directly to amplifier 103. Since the RF signal is absent (i.e., X noise) speaker 104 outputs noise at a level determined only by the position of gain controller 109 in amplifier 103.
   When gain controller 109 is in "high volume" position then speaker 104 might output the above mentioned fully amplified noise that is unwanted.

Further, the transition from (iii) to (iv) can cause a sudden increase of the amplitude of signals Y and Z. This is not wanted either. Depending on the type of amplifier 103, the noise at speaker 104 can reach or cross over the pain threshold (about 120 dB(A) sound level). Since switch 140 is operated by the user, disabling the attenuation can occur by chance at any time.

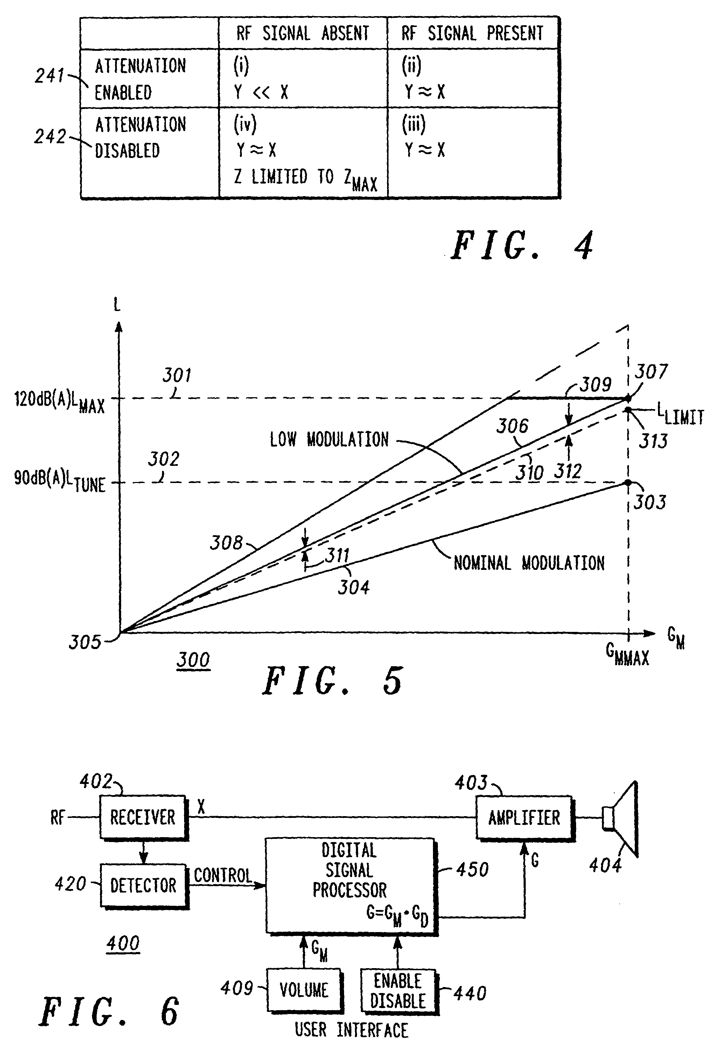

FIG. 3 illustrates a simplified block diagram of radio 200 having extended squelch circuit 210 according to the present invention. It is an advantage of radio 200 at any time to limit noise at the speaker but to allow voice reproduction without any limitations.

Radio 200 comprises antenna 201, receiver 202, signal line 205 (signal X), detector 220, manually operated switch 240 (positions 241, 242), signal line 206 (signal Y), amplifier 203, line 207 (signal Z) and speaker 204.

Receiver 202 derives intermediate signal X from the RF signal; amplifier 203 temporarily receives signal X (in the form of signal Y) and drives speaker 204; squelch circuit 210 is user defined either ENABLED or DISABLED, and (when ENABLED) allows amplifier 203 to receive signal X only when the RF signal is present. It is an advantage of that if squelch circuit 210 is DISABLED by the user, squelch circuit 210 still reduces the gain G of amplifier 203 when the RF signal is absent.

In FIGS. 1 and 3, reference numbers 101/201, 102/202, 105/205, 106/106, 107/207, 109/209, 120/220, 122/222, 130/230, 140/240, 141/241, 142/242, 104/204 stand for analogous components. Radios 200 has substantially the same user operated interfaces as radio 100: switch 240 and gain controller 209.

In comparison to radio 100, radio 200 of the present invention has extended squelch circuit 210 (dashed frame) that also comprises control path 223 from detector 220 to variable gain amplifier 203. In other words, variable gain amplifier 203 does not only have manually operated controller 209, but additionally has signal controlled gain control path 223.

For convenience of explanation, the invention is described by illustrating in FIG. 3 separate functional blocks such as attenuator 230, switch 240, variable gain amplifier 203, etc. Persons of skill in the art are able to combine some or all blocks and implement the present invention by a digital signal processor (DSP) or other microprocessor that digitally changes the signals. Especially for the DSP implementation, means to alter signal amplitudes can be simplified to a single hardware component. An embodiment of the present invention with a DSP implementation is explained in connection with FIG. 6.

Having enabling and disabling of the squelch function illustrated by switch 240 in the signal path from line 205 to line 206 is convenient but not necessary for the present invention. User defined enabling and disabling can also be accomplished by influencing the operation of detector 220.

As it will be explained in the following, the gain of amplifier 203 is not only controlled by the user (as in the prior art), but also limited by a control signal CONTROL generated by detector 220. Conveniently, an overall gain G of amplifier 203 is defined as the ratio between the amplitudes of signals Z and Y (G = Z / Y). G comprises manually controllable gain G_{M} and detector controllable gain G_{D} (via path 223), preferably related by G = G_{M} * G_{D}.

Having squelch circuit 210 coupled between receiver 202 and amplifier 203 is convenient for explanation, but not necessary for practicing the present invention. Circuit 210 can also be coupled differently, without departing from the scope of the present invention.

FIG. 4 illustrates a state diagram for the radio of FIG. 2. States (i)(ii) and (iii) are similar to that of radio 100 (FIGS. 1-2). In states (ii) and (iii) where the RF signal is present, detector 220 does substantially not influence the gain G of amplifier 203 (i.e. G_{D} ≈ 1). In state (i), detector 220 causes amplitude reduction in attenuator 230.

Compared to radio 100, state (iv) of radio 200 is different. In state (iv), attenuation is disabled so that switch 240 also forwards signal X directly to amplifier 203 (as above). Detector 220 has detected the absence of the RF signal (i.e., X noise) and forwards control signal CONTROL to amplifier 203. Speaker 204 outputs noise at a level now determined by CONTROL (path 223) but no more determined by the position of gain controller 209 in amplifier 203. Even if controller 209 is in "high volume" position then speaker 204 either stays silent or outputs noise at a limit level (Z_{MAX}) that is still comfortable to the user (e.g., below 60 dB(A)). Outputting the above mentioned fully amplified noise is avoided. This has a variety of advantages, among others reducing the mentioned safety and health concerns. The car driver is no longer distracted and can fully concentrate on the traffic. Further, damage to the ear is also prevented.

In a further embodiment of the invention, detector 220 causes amplifier 203 to chance its gain G_{D} gradually.

In a first example, after the transition from state (iii) and (iv), i.e. after detector 220 has detected the absence of the RF signal, detector 220 causes amplifier 203 to first immediately reduce gain G_{D} and second to gradually increase gain G_{D} over a predetermined time period (e.g., up to 5 seconds). Speaker 204 outputs noise with an increasing level thus allowing the user to enable attenuation (going to state (i)).

In a second example, state transitions (i) to (ii) and (iv) to (iii) are optionally accompanied by an gradually increased gain G_{D}. This has the advantage that in case of high audio modulation, the voice signal initially presented to the user has a comfortable low level.

FIG. 5 illustrates a simplified sound-level(L)-to-gain(G_{M}) diagram 300 of radio 200 according to the present invention. The sound level (in dB(A)) of the acoustic signal (provided by speaker 204) is illustrated on the ordinate axis. The manually controllable gain G_{M} (e.g., up to 70 dB(V)) is illustrated on the abscissa axis.

Dashed line 301 indicates the pain threshold L_{MAX} at 120 dB(A); and dashed line 302 indicates the maximum sound level L_{TUNE} (e.g., 90 db(A)) that is reached when the user tunes the gain G_{M} to its maximum G_{M MAX} and the voice signal is nominally modulated onto the RF signal (cf. point 303). Depending on the modulation, speaker 204 provides an acoustic signal, cf. line 304 (NOMINAL) from origin 305 to point 303.

Lines 308 (origin 305 to line 301) and in continuation line 309 along with line 301 (L_{MAX}) illustrate noise that is caused by carrier absence in the RF signal. Attenuator 230 limits the sound level to L_{MAX} or to any predetermined value below (typically zero).

Line 306 from origin 305 to point 307 (L_{MAX} at G_{M MAX}) indicate an additional overdrive range useful for low modulated RF signals (voice).

In a still further embodiment, the amount by which G_{D} is altered in state (iv) depends on the magnitude of G_{M}. This is illustrated by dashed line 310 (origin 305 to point 313 L_{LIMIT} < L_{MAX}, G_{M MAX}). Lines 310 indicates noise; even if manual controlled gain is at G_{M MAX}, the resulting sound level at speaker 204 is below L_{MAX}. The difference between G_{D} for noise (state (iv), line 310) and G_{D} ≈ 1 for voice (line 306) is larger for higher G_{M} (cf. difference 312) than for lower G_{M} (cf. difference 311).

A method according to the present invention is described in reference to FIG. 4 as a method for operating radio (e.g., 200, 400) that receives an RF signal and forwards an audio signal ("voice") to the speaker. As described above, the radio has an attenuation function (cf. attenuator 230, DSP 450) acting on the audio signal (X,Y,Z). States (i) (ii) (iii) and (iv) are considered as method steps. A first group of steps (i) and (ii) relates to a first mode when the attenuation function is enabled by the user; and a second group of steps (iv) and (iii) relates to a second mode when the attenuation function is disabled by the user. Within both groups of steps, the steps are performed consecutively and in repetitions, that means in any order.

More in detail, the method performs as follows: In the first mode (ENABLED), depending on the absence or presence of the RF signal, the radio in step (i) attenuates the audio signal and in step (ii) directly forwards the audio signal, respectively; in the second mode (DISABLED), depending on the absence or presence of the RF signal, the radio in step (iv) limits the magnitude of the audio signal and in step (iii) directly forwards the audio signal, respectively.

FIG. 6 illustrates a simplified block diagram of radio 400 according to the present invention in a DSP implementation. In FIGS. 3 and 6, reference numbers 200/400, 202/402, 203/403, 204/404, 209/409, 420/220, 240/440 and symbols X, RF, G, G_{M}, G_{D}, CONTROL stand for analogous elements, signals or values. Radio 400 comprises receiver 402, amplifier 403, detector 420, speaker 404, user interfaces 409 and 440, and DSP 450.

Receiver 402 derives intermediate signal X (i.e. voice or noise) from the RF signal. Amplifier 403 forwards signal X to speaker 404. By monitoring receiver 402, detector 420 provides detector signal CONTROL to indicate a degree of presence of the RF signal (e.g., presence or absence). Interface 409 receives from the user a first representation of a desired amplifier gain G_{M}. Interface 440 receives from the user a second representation ENABLE/DISABLE indicating that the user either (cf. FIG. 4, states (i) (ii) ENABLE) desires substantial zero gain amplification (e.g., muting the noise) in case the degree of presence is below a predetermined threshold (e.g., RF absent), or (states (iii)(iv) DISABLE) that the user desires amplification by the desired amplifier gain G_{M} independently from the degree of presence.

DSP 450 receives detector signal CONTROL, both representations (G_{M}, ENABLE/DISABLE) and provides gain control signal G for amplifier 403. Under the conditions that (a) the second representation indicates the user's desire for amplification by the desired amplifier gain G_{M} independently from the degree of presence (i.e., DISABLE) and that (b) the degree of presence is below the predetermined threshold, DSP 450 provides gain control signal G such that amplifier 403 at least temporarily (i.e., for a predetermined time period after transition (iv) (iii)) amplifies with substantially zero gain (muting).

Preferably, detector 420 provides CONTROL such that the degree of presence of the RF signal is either presence or absence of the RF signal. In an alternative, detector 420 provides CONTROL such that the degree of presence of the RF signal is defined by the modulation degree by which information is modulated onto the RF signal.

As mentioned above in connection with FIG. 5 (line 310, distances 311, 312), DSP 450 provides (at least in case that conditions (a)(b) are in compliance) the gain control signal G is proportional to the desired amplification gain G_{M}. Optionally, the gain control signal G has a magnitude that increases within a predetermined time period, thus giving the user the possibility to enable muting by toggling the second representation to ENABLE.

Persons of skill in the art are able to program DSP 450 without the need of further explanation herein.

While the invention has been described in terms of particular structures and methods, those of skill in the art will understand based on the description herein that it is not limited merely to such examples and that the full scope of the invention is properly determined by the claims that follow.

## Claims

1. A radio (200) having a receiver (202) to derive an intermediate signal (X) from a radio frequency (RF) signal; an amplifier (203) to temporarily receive the intermediate signal (X) and to drive a speaker (204); and a squelch circuit (210) that is user defined either in an enabled mode or in an disabled mode, and that in the enabled mode allows the amplifier (203) to receive the intermediate signal only when the RF signal is present, said radio (200) **characterized in that** said squelch circuit (210) in said disabled mode reduces the gain of said amplifier when the RF signal is absent.

2. The radio (200) of claim 1 wherein said squelch circuit (210) in said disabled mode, after having detected the absence of the RF signal, gradually increases the gain of said amplifier (203), thus allowing the user to choose the enabled mode.

3. The radio (200) of claim 1 wherein said squelch circuit (210) in said disabled mode, after having detected the absence of the RF signal, first immediately reduces the gain and second gradually increases the gain.

4. A radio (400) having:
a receiver (402) to derive an intermediate signal (X) from a radio frequency (RF) signal;
an amplifier (403) to forward the intermediate signal (X) to a speaker (404);
a detector (420) to provide a detector signal (CONTROL) that indicates a degree of presence of the RF signal by monitoring the receiver (402);
a first interface (409) to receive from the user a first representation of a desired amplifier gain (G_{M});
a second interface (440) to receive from the user a second representation (ENABLE/DISABLE) indicating that the user either
(i)(ii) desires substantial zero gain amplification by said amplifier (403) in case the degree of presence is below a predetermined threshold, or
(iii) (iv) desires amplification by said desired amplifier gain (G_{M}) independently from said degree of presence; and
a digital signal processor (DSP 450), receiving said detector signal (CONTROL), said first (G_{M}) and second (ENABLE/DISABLE) representations, and providing a gain control signal (G) for said amplifier (403) such that under the condition that
• the second representation indicates that the user desires amplification by said desired amplifier gain (G_{M}) independently from said degree of presence (DISABLE) and
• the degree of presence is below said predetermined threshold,
said DSP (450) provides said gain control signal (G) such that said amplifier (403) at least temporarily amplifies with substantially zero gain.

5. The radio (400) of claim 4 wherein said detector (420) provides said detector signal (CONTROL) such that the degree of presence of the RF signal is either presence or absence of said RF signal.

6. The radio (400) of claim 4 wherein said detector (420) provides said detector signal (CONTROL) such that the degree of presence of the RF signal is defined by modulation degree by which information is modulated onto said RF signal.

7. The radio (400) of claim 4 wherein said DSP provides - in case that said condition is in compliance - said gain control signal proportional to said desired amplification gain (G_{M}).

8. The radio (400) of claim 4 wherein said DSP provides - in case that said condition is in compliance - said gain control signal with a magnitude that increases within a predetermined time period.

9. A method for operating a radio that receives a radio frequency (RF) signal and forwards an audio signal to a speaker, said radio having an attenuation function acting on said audio signal, said attenuation function in a first mode being enabled by the user and in a second mode being disabled by the user; said method comprising the steps of:
in the first mode, depending on the absence or presence of the RF signal, (i) the radio attenuates said audio signal and (ii) directly forwards said audio signal, respectively; and
in the second mode, depending on the absence or presence of the RF signal, (iv) the radio limits the magnitude of said audio signal and (iii) directly forwards said audio signal, respectively.

## Patentansprüche

1. Funkeinrichtung (200) mit einem Empfänger (202), um ein Zwischensignal (X) von einem Radiofrequenz(RF)-Signal abzuleiten; einem Verstärker (203), um das Zwischensignal (X) vorübergehend zu empfangen und um einen Lautsprecher (204) zu treiben; und einer Rauschunterdrückungsschaltung (210), die anwenderdefiniert entweder in einem freigegebenen Modus oder in einem gesperrten Modus ist und die dem Verstärker (203) in dem freigegebenen Modus erlaubt, das Zwischensignal nur zu empfangen, wenn das RF-Signal vorhanden ist, wobei die Funkeinrichtung (200) **dadurch gekennzeichnet ist, dass** die Rauschunterdrückungsschaltung (210) in dem gesperrten Modus die Verstärkung des Verstärkers verringert, wenn das RF-Signal nicht vorhanden ist.

2. Funkeinrichtung (200) gemäß Anspruch 1, bei der die Rauschunterdrückungsschaltung (210) in dem gesperrten Modus die Verstärkung des Verstärkers (203) Schritt für Schritt erhöht, nachdem sie die Abwesenheit des RF-Signals detektiert hat, wodurch dem Anwender gestattet wird, den freigegebenen Modus zu wählen.

3. Funkeinrichtung (200) gemäß Anspruch 1, bei der die Rauschunterdrückungsschaltung (210) in dem gesperrten Modus zuerst sofort die Verstärkung verringert und dann die Verstärkung Schritt für Schritt erhöht, nachdem sie die Abwesenheit des RF-Signals detektiert hat.

4. Funkeinrichtung (400), die folgendes umfasst:
einen Empfänger (402), um ein Zwischensignal (X) von einem Radiofrequenz(RF)-Signal abzuleiten;
einen Verstärker (403), um das Zwischensignal (X) an einen Lautsprecher (404) weiterzuleiten;
einen Detektor (420), um ein Detektorsignal (CONTROL) zur Verfügung zu stellen, das einen Anwesenheitsgrad des RF-Signals durch Überwachen des Empfängers (402) anzeigt;
eine erste Schnittstelle (409), um von dem Anwender eine erste Darstellung eines gewünschten Verstärkungsfaktors (G_{M}) zu empfangen;
eine zweite Schnittstelle (440), um von dem Anwender eine zweite Darstellung (FREIGEBEN/SPERREN) zu empfangen, die anzeigt, dass der Anwender entweder
(i) (ii) für den Fall, dass der Anwesenheitsgrad unterhalb eines vorbestimmten Schwellenwertes liegt, eine substantielle Nullverstärkung durch den Verstärker (403) wünscht, oder
(iii) (iv) eine Verstärkung um den gewünschten Verstärkungsfaktor (G_{M}) unabhängig von dem Anwesenheitsgrad wünscht; und
einen digitalen Signalprozessor (DSP 450), der das Detektorsignal (CONTROL), die erste (G_{M}) und zweite (FREIGEBEN/SPERREN) Darstellung empfängt und ein Verstärkunkungssteuersignal (G) für den Verstärker (403) zur Verfügung stellt, so dass, unter der Bedingung, dass
• die zweite Darstellung anzeigt, dass der Anwender eine Verstärkung um den gewünschten Verstärkungsfaktor (G_{M}) unabhängig von dem Anwesenheitsgrad (SPERREN) wünscht und
• der Anwesenheitsgrad unterhalb des vorbestimmten Schwellenwertes liegt,
der DSP (450) das Verstärkungssteuersignal (G) so zur Verfügung stellt, dass der Verstärker (403) zumindest vorübergehend mit einer substantiellen Null-Verstärkung verstärkt.

5. Funkreinrichtung (400) gemäß Anspruch 4, wobei der Detektor (420) das Detektorsignal (CONTROL) zur Verfügung stellt, so dass der Anwesenheitsgrad des RF-Signals entweder Anwesenheit oder Abwesenheit des RF-Signals ist.

6. Funkeinrichtung (400) gemäß Anspruch 4, wobei der Detektor (420) das Detektorsignal (CONTROL) zur Verfügung stellt, so dass der Anwesenheitsgrad des RF-Signals durch den Modulationsgrad definiert wird, durch den Information auf das RF-Signal moduliert wird.

7. Funkeinrichtung (400) gemäß Anspruch 4, wobei der DSP - für den Fall, dass die Bedingung erfüllt wird - dafür sorgt, dass das Verstärkungssteuersignal proportional zu dem gewünschten Verstärkungsfaktor (G_{M}) ist.

8. Funkeinrichtung (400) gemäß Anspruch 4, wobei der DSP - für den Fall, dass die Bedingung erfüllt wird - dafür sorgt, dass das Verstärkungssteuersignal eine Stärke hat, die in einer vorbestimmten Zeitperiode zunimmt.

9. Verfahren zum Betreiben einer Funkeinrichtung, die ein Radiofrequenz(RF)-Signal empfängt und ein Audiosignal an einen Lautsprecher weiterleitet, wobei die Funkeinrichtung eine Dämpfungsfunktion hat, die auf das Audiosignal wirkt, wobei die Dämpfungsfunktion in einem ersten Modus durch den Anwender freigegeben wird und in einem zweiten Modus durch den Anwender gesperrt wird; wobei das Verfahren die folgenden Schritte umfasst:
in dem ersten Modus (i) dämpft die Funkeinrichtung das Audiosignal oder (ii) leitet das Audiosignal direkt weiter, jeweils in Abhängigkeit von der Abwesenheit oder Anwesenheit des RF-Signals; und
in dem zweiten Modus (iv) begrenzt die Funkeinrichtung die Stärke des Audiosignals oder (iii) leitet das Audiosignal direkt weiter, jeweils in Abhängigkeit von der Abwesenheit oder Anwesenheit des RF-Signals.

## Revendications

1. Poste radio (200) comportant un récepteur (202) pour dériver un signal intermédiaire (X) à partir d'un signal à fréquence radio (RF); un amplificateur (203) pour recevoir temporairement le signal intermédiaire (X) et commander un haut-parleur (204); et un circuit d'assourdissement (210) défini par l'utilisateur soit dans un mode validé soit dans un mode invalidé, et qui, dans le mode validé, permet à l'amplificateur (203) de recevoir le signal intermédiaire uniquement lorsque le signal RF est présent, ledit poste radio (200) étant **caractérisé en ce que** ledit circuit d'assourdissement (210) dans ledit mode invalidé réduit le gain dudit amplificateur lorsque le signal RF est absent.

2. Poste radio (200) selon la revendication 1, dans lequel, dans ledit mode invalidé, après avoir détecté l'absence du signal RF, ledit circuit d'assourdissement (210) augmente graduellement le gain dudit amplificateur (203) en permettant ainsi à l'utilisateur de choisir le mode validé.

3. Poste radio (200) selon la revendication 1, dans lequel, dans ledit mode validé, après avoir détecté l'absence du signal RF, ledit circuit d'assourdissement (210) réduit tout d'abord immédiatement le gain et en second lieu réduit graduellement le gain.

4. Poste radio (400) comportant :
un récepteur (402) pour dériver un signal intermédiaire (X) à partir d'un signal à fréquence radio (RF);
un amplificateur (403) pour envoyer le signal intermédiaire (X) à un haut-parleur (404);
un détecteur (420) pour délivrer un signal du détecteur (CONTROL) qui indique un degré de présence du signal RF au moyen d'un contrôle du récepteur (402);
une première interface (409) pour recevoir, de la part de l'utilisateur, une première représentation d'un gain désiré (G_{M}) de l'amplificateur;
une seconde interface (440) pour recevoir, de la part de l'utilisateur, une seconde représentation (ENABLE/DISABLE) indiquant que l'utilisateur
(i) (ii) désire une amplification de gain sensiblement nulle par ledit amplificateur (403) dans le plan où le degré de présence est inférieur à un seuil prédéterminé; ou
(iii) (iv) désire une amplification avec ledit gain désiré (G_{M}) de l'amplificateur indépendamment dudit degré de présence; et
un processeur de signaux numériques (DSP 450), qui reçoit ledit signal de détecteur (CONTROL), ladite première représentation (G_{M}) et ladite seconde représentation (ENABLE /DISABLE) et qui fournit un signal de commande de gain (G) pour ledit amplificateur (403) de telle sorte que, dans la condition où
• la seconde représentation indique que l'utilisateur désire une amplification et ce dudit gain désiré (G_{M}) de l'amplificateur, indépendamment dudit degré de présence (DISABLE), et
• le degré de présence est inférieur audit seuil prédéterminé,
ledit processeur DSP (450) délivre ledit signal de commande de gain (G) de telle sorte que ledit amplificateur (403) réalise une amplification au moins temporaire avec un gain sensiblement nul.

5. Poste radio (400) selon la revendication 4, dans lequel ledit détecteur (420) délivre ledit signal de détecteur (CONTROL) de telle sorte que le degré de présence du signal RF est soit la présence, soit l'absence dudit signal RF.

6. Poste radio (400) selon la revendication 4, dans lequel ledit détecteur (420) délivre ledit signal de détecteur (CONTROL) de telle sorte que le degré de présence du signal RF est défini par un degré de modulation, au moyen duquel une information est appliquée par modulation sur ledit signal RF.

7. Poste radio (400) selon la revendication 4, dans lequel ledit processeur DSP délivre - dans le cas où ladite condition est satisfaite - ledit signal de commande de gain proportionnel audit gain désiré d'amplification (G_{M}).

8. Poste radio (400) selon la revendication 4, dans lequel ledit processeur DSP fournit - dans le cas où ladite condition est satisfaite - ledit signal de commande de gain avec une amplitude qui augmente pendant un intervalle de temps prédéterminé.

9. Procédé pour faire fonctionner un poste radio qui reçoit un signal à fréquence radio (RF) et transmet un signal audio à un haut-parleur, ledit poste radio comportant une fonction d'atténuation agissant sur ledit signal audio, ladite fonction d'atténuation étant, dans un premier mode, validée par l'utilisateur et, dans un second mode, invalidée par l'utilisateur; ledit procédé comprenant les étapes consistant à :
dans le premier mode, en fonction de l'absence ou de la présence du signal (RF), (i) le poste radio atténue ledit signal audio et (ii) transmet directement ledit signal audio, respectivement; et
dans le second mode, en fonction de l'absence ou de la présence du signal RF, (iv) le poste radio limite l'amplitude dudit signal audio et (iii) transmet directement ledit signal audio, respectivement.
